# EUROPEAN PATENT APPLICATION

(11) **EP 0 824 266 A2**
(43) Date of publication of application: **18.02.1998**
(21) Application number: 97113474.7
(22) Date of filing: 05.08.1997
(51) Int. Cl.: H01L 21/00, C23C 16/54

(54) **Substrate processing apparatus**

(30) Priority: 05.08.1996 JP 223076/96
(71) Applicant: KOKUSAI ELECTRIC CO., LTD., Tokyo 164 (JP)
(72) Inventor: Toyoda, Kazuyuki, Kokusai Electric Co., Ltd., Higashi-Nakano, Nakano-ku, Tokyo 164 (JP); Suda, Atsuhiko, Kokusai Electric Co., Ltd., Higashi-Nakano, Nakano-ku, Tokyo 164 (JP); Makiguchi, Issei, Kokusai Electric Co., Ltd., Higashi-Nakano, Nakano-ku, Tokyo 164 (JP); Tanaka, Tsutomu, c/o Kokusai Electric Co., Ltd., Higashi-Nakano, Nakano-ku, Tokyo 164 (JP); Suzuki, Sadayuki, c/o Kokusai Electric Co., Ltd., Higashi-Nakano, Nakano-ku, Tokyo 164 (JP); Nomura, Shinichi, c/o Kokusai Electric Co., Ltd., Higashi-Nakano, Nakano-ku, Tokyo 164 (JP); Takeshita, Mitsunori, Kokusai Electric Co., Ltd., Higashi-Nakano, Nakano-ku, Tokyo 164 (JP)
(74) Representative: Harrison, Michael Charles

(57) **Abstract**

A substrate processing apparatus comprises a substrate transfer section (100), a plurality of modules (300, 400) and a first substrate transfer robot (20) provided in the substrate transfer section (100) and capable of transferring substrates to the plurality of modules (300, 400). The plurality of modules (300, 400) are piled up, separately from one another, in a vertical direction. Each of the plurality of modules (300, 400) are detachably mounted to the substrate transfer section (100) and includes a substrate processing chamber (56, 454), an intermediate chamber (54, 452), a first gate valve (66, 464), a second gate valve (64, 462), and a second substrate transfer robot disposed in the intermediate chamber (54, 452). Preferably, the substrate processing apparatus further comprises a second intermediate chamber (52) having a substrate holder (70) therein and disposed between the intermediate chamber (54, 452) and the substrate transfer section (100), and a third gate valve (62). The invention provide a substrate processing apparatus which requires a small floor space and which is capable of accomplishing a high net working rate.

## Description

### BACKGROUND OF THE INVENTION

### 1. Field of the Invention

The present invention relates to a substrate processing apparatus, more particularly, to a semiconductor wafer processing apparatus, and still more particularly, to a semiconductor wafer processing apparatus for processing a semiconductor wafer utilizing plasma, such as a plasma enhanced etching apparatus, a plasma enhanced CVD (Chemical Vapor Deposition) apparatus and a plasma enhanced ashing apparatus.

### 2. Description of the Related Art

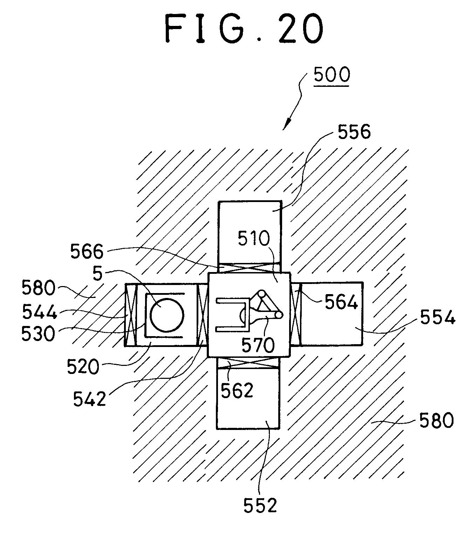

Fig.20 shows an example of a plasma CVD apparatus 500 among conventional semiconductor wafer processing apparatuses using plasma.

Units, i.e., reaction chambers 552, 554, a cooling chamber 556 and a cassette chamber 520 are provided, through gate valves 562, 564, 566 and 542, respectively, around a load lock chamber 510 having a transfer robot 570 therein. Each of the units is formed into an airtight structure. The load lock chamber 510 is further provided with an outer gate valve 544 for taking a cassette 530 in and out. This plasma CVD apparatus 500 includes the two reaction chambers 552 and 554 so as to increase the number of wafers to be processed per hour, i.e., so as to increase a throughput.

In Fig.20, a hatched area indicates a maintenance space 580 for the reaction chambers 552 and 554, etc.

The operation of the plasma CVD apparatus 500 will be described next.

An evacuating pump (not shown) evacuates the load lock chamber 510, the reaction chambers 552, 554 and the cooling chamber 556, and these chambers are always kept under a reduced pressure.

When the cassette chamber 520 is in an atmospheric pressure condition, the outer gate valve 544 is opened to set the cassette 530 in which a plurality of wafers 5 are set. Then, the outer gate valve 544 is closed, and the evacuating pump that is not shown evacuates the cassette chamber 520 after that.

When pressures in the cassette chamber 520 and the load lock chamber 510 becomes substantially equal to each other, the gate valve 542 between the cassette chamber 520 and the load lock chamber 510 and the gate valve 562 (564) between the load lock chamber 510 and the reaction chamber 552 (554) are opened, and the transfer robot 570 in the load lock chamber 510 transfers the wafer 5 in the cassette 530 into the reaction chamber 552 or 554 to process the wafer 5.

After the processing in the reaction chamber 552 or 554 is completed, it is necessary to return the wafer 5 into the cassette 530 of the cassette chamber 520 using the transfer robot 570. However, in the case of the plasma CVD apparatus, the wafer 5 is usually heated up to around 300°C to be processed in the reaction chamber 552 (554). Therefore, depending on materials of the cassette 530, the wafer 5 can not be accommodated in the cassette 530 as it is in many cases. Therefore, it is necessary to insert the processed wafer 5 into the cooling chamber 556 to cool the wafer 5.

When the wafer 5 in the cooling chamber 556 are sufficiently cooled down so that the wafer 5 can safely be accommodated in the cassette 530, the wafer 5 are returned to the cassette 530 of the cassette chamber 520 using the transfer robot 570.

The above described series of operations are repeated to process the wafers 5 sequentially.

The apparatus shown in Fig.20 is provided with two reaction chambers in addition to one cooling chamber and one cassette chamber. In order to further increase the throughput, it is necessary to increase the number of corners or angles of the load lock chamber 510, that is to increase the number of the sides of the load lock chamber 510, so as to increase the number of reaction chambers 552 and 554.

To do so, however, the load lock chamber 510 must be enlarged in size, resulting in increasing the area occupied by the entire apparatus including the enlarged load lock chamber 510, the increased number of the reaction chambers 552, 554 and the maintenance space therefor.

A plant for manufacturing semiconductor devices which requires clean room facilities costs a vast sum of money. A floor space of the plant is determined depending on sizes of apparatuses which are introduced as manufacturing equipment. If the floor space occupied by each of the apparatuses is small, the cost of the plant equipment can be lowered and therefore, an apparatus occupying a small floor space is desired. Further, in addition to the requirement of the small floor space, it is also desired to increase a net working rate or an availability factor of the apparatus.

### SUMMARY OF THE INVENTION

It is, therefore, a major object of the present invention to provide a substrate processing apparatus which requires a small floor space and which is capable of accomplishing a high net working rate.

According to a first aspect of the present invention, there is a provided a first substrate processing apparatus, comprising:
a substrate transfer section;
a plurality of modules, each of the plurality of modules being detachably attached to the substrate transfer section; and
first substrate transfer means provided in the substrate transfer section and capable of transferring a substrate or substrates to the plurality of modules,
   wherein the plurality of modules are piled up, separately from one another, in a substantially vertical direction,
   wherein each of the plurality of modules comprises:
   a substrate processing chamber, having a hermetic structure, for processing the substrate or the substrates;
   an intermediate chamber having a hermetic structure and being provided between the substrate processing chamber and the substrate transfer section;
   a first valve provided between the substrate processing chamber and the intermediate chamber, the first valve being capable of establishing hermetic isolation between the substrate processing chamber and the intermediate chamber when the first valve is closed and being capable of allowing the substrate or the substrates to pass through the first valve when the first valve is opened; and
   a second valve provided between the intermediate chamber and the substrate transfer section, the second valve being capable of establishing hermetic isolation between the intermediate chamber and the substrate transfer section when the second valve is closed and being capable of allowing the substrate or the substrates to pass through the second valve when the second valve is opened, and
      wherein the intermediate chamber is provided with second substrate transfer means capable of transferring the substrate or the substrates to the substrate processing chamber.

In the first substrate processing apparatus of the present invention, because the plurality of modules are piled up in a substantially vertical direction, even though the plurality of modules are used to enhance the processing efficiency of the substrate, an area of the clean room occupied by the substrate processing apparatus is not increased, and a maintenance region for the apparatus is not increased.

Further, in the first substrate processing apparatus, because the plurality of the modules piled up in the substantially vertical direction are separate from one another and each of the plurality of the modules is detachably attached to the substrate transfer section, when any one of the modules requires a maintenance, it is possible to take out only the one module which requires the maintenance. While the maintenance for the module is conducted, other modules can be operated and as a result, a net working rate of the substrate processing apparatus is remarkably enhanced.

Furthermore, in the first substrate processing apparatus, because the plurality of modules piled up in the vertical direction are separate from one another and each of the plurality of the modules is detachably attached to the substrate transfer section, when any one of the modules requires a maintenance, it is possible to take out only the one module which requires the maintenance and to conduct the maintenance therefor. When the maintenance is completed, parallel and height relationships and so forth between the second substrate transfer means and the substrate processing chamber can be adjusted beforehand to allow the substrate to be transferred between the substrate processing chamber and the second substrate transfer means in the module. After the adjustment, the module is attached to the substrate transfer section again. Because it is possible to conduct, in the module, the adjustment for the substrate transfer between the substrate processing chamber and the second substrate transfer means beforehand, such adjustment operation can easily and accurately be conducted. After that, when the module for which the maintenance has been conducted is attached to the substrate transfer section, it is unnecessary anymore to conduct the adjustment for the substrate transfer between the substrate processing chamber and the second substrate transfer means and therefore, it is possible to remarkably enhance the net working rate of the substrate processing apparatus.

Also, because the plurality of modules are separate from one another and each of the plurality of the modules are detachably attached to the substrate transfer section, the number of modules to be attached to the substrate transfer section can be suitably selected in accordance with a required number of the substrates to be processed per hour and a type of processing.

Further, each of the plurality of modules comprises: a substrate processing chamber, having a hermetic structure, for processing the substrate or the substrates; an intermediate chamber having a hermetic structure and being provided between the substrate processing chamber and the substrate transfer section; a first valve provided between the substrate processing chamber and the intermediate chamber, the first valve being capable of establishing hermetic isolation between the substrate processing chamber and the intermediate chamber when the first valve is closed and being capable of allowing the substrate or the substrates to pass through the first valve when the first valve is opened; and a second valve provided between the intermediate chamber and the substrate transfer section, the second valve being capable of establishing hermetic isolation between the intermediate chamber and the substrate transfer section when the second valve is closed and being capable of allowing the substrate or the substrates to pass through the second valve when the second valve is opened. Therefore, it is possible to independently keep the intermediate chamber and the substrate processing chamber in each of the modules in respective hermetically sealed states. Also, in each of the modules and between the modules, it is possible to independently bring an interior of each of the intermediate chamber and the substrate processing chamber into a predetermined gas atmosphere or a vacuum atmosphere, and the substrate or the substrates can be moved between the substrate processing chamber and the intermediate chamber, and between the intermediate chamber and the substrate transfer section, respectively. Because it is possible to independently keep the intermediate chamber and the substrate processing chamber in respective hermetically sealed states, the intermediate chamber can function as a load lock chamber. As the first valve, a gate valve is preferably used.

Further, because the intermediate chamber of each of the modules is provided with the second substrate transfer means capable of transferring the substrate or the substrates to the substrate processing chamber, it is possible to transfer the substrate or the substrates into and out from the substrate processing chamber irrespective of the processing states of the substrate processing chambers of other modules. When a semiconductor wafer is used as the substrate for example, the heating time of the substrate in the substrate processing chamber influences distributing state of impurities in the semiconductor wafer, which also influences a characteristic of a semiconductor device. Therefore, it is necessary to keep the heating time constant. In the present invention, because each of the modules is provided with the substrate processing chamber and substrate transfer means, the substrate or the substrates can be transferred out irrespective of the processing states in other substrate processing chambers and as a result, a time period in which the substrate is heated in each of the modules can be kept constant.

Preferably, each of the plurality of modules comprises:
the substrate processing chamber, having a hermetic structure of vacuum level, for processing the substrate or the substrates;
the intermediate chamber having a hermetic structure of vacuum level and being provided between the substrate processing chamber and the substrate transfer section;
the first valve provided between the substrate processing chamber and the intermediate chamber, the first valve being capable of establishing hermetic isolation of vacuum level between the substrate processing chamber and the intermediate chamber when the first valve is closed and being capable of allowing the substrate or the substrates to pass through the first valve when the first valve is opened; and
the second valve provided between the intermediate chamber and the substrate transfer section, the second valve being capable of establishing hermetic isolation of vacuum level between the intermediate chamber and the substrate transfer section when the second valve is closed and being capable of allowing the substrate or the substrates to pass through the second valve when the second valve is opened.

With the above described features, it is possible to independently keep the intermediate chamber and the substrate processing chamber of each of the modules in respective hermetically sealed states of vacuum level. In each of the modules and between the modules, it is possible to independently bring an interior of each of the intermediate chamber and the substrate processing chamber into a predetermined vacuum atmosphere, and the substrate or the substrates can be moved between the substrate processing chamber and the intermediate chamber, and between the intermediate chamber and the substrate transfer section, respectively. Because it is possible to independently keep the intermediate chamber and the substrate processing chamber in respective hermetically sealed states of vacuum level, the intermediate chamber can function as a load lock chamber used under vacuum.

Because the intermediate chamber having such a hermetic structure of vacuum level is provided with the second substrate transfer means capable of transferring the substrate or the substrates to the substrate processing chamber, the substrate or the substrates can be transferred under atmospheric pressure to each of the modules by the first substrate transfer means provided in the substrate transfer section, and the transfer of the substrate or the substrates under vacuum can be performed by the second substrate transfer means provided in the intermediate chamber of each of the modules. Therefore, it is unnecessary that all the regions in which mechanisms for transferring the substrate are installed have hermetic structures of vacuum level. That is, the substrate transfer section which transfers the substrate or the substrates to each of the modules can be a region in which the substrate or the substrates are transferred under atmospheric pressure, and a region having a hermetic structure of vacuum level can be divided into the intermediate chamber of each of the modules. As a result, it is possible to simplify the structures of the substrate transfer section and the first substrate transfer means, and they can be manufactured at a low price. A volume of the intermediate chamber of each of the modules can be reduced, and even though the wall thickness of the intermediate chamber is made thin, its strength can be maintained and as a result, it can be manufactured at a low price. Further, it is possible to minimize a vertical movement of the second substrate transfer means provided in the intermediate chamber, it can be manufactured at a low price. It is also possible to suppress, to the minimum, particles which may be generated from the driving section of the second substrate transfer means in the intermediate chamber having the hermetic structure of vacuum level.

Both the substrate processing chamber and the intermediate chamber have hermetic structures of vacuum level and thus, it is preferable that both the chambers can be reduced in pressure. In such a case, it is more preferable that both the chambers can be reduced in pressure independently.

Preferably, the intermediate chamber of each of the plurality of modules is further provided with substrate holding means capable of holding the substrate or the substrates, the substrate holding means being positioned closer to the substrate transfer section than the second substrate transfer means.

By providing the substrate holding means in addition to the second substrate transfer means in this manner, it is possible to separate the holding function and the transferring function of the substrate. Therefore, for example, while the substrate holding means holds some substrate or substrates for cooling, the substrate transfer means can transfer other substrate or substrates to the substrate processing chamber and therefore, the substrate processing can be effected more efficiently.

Because the substrate holding means is located closer to the substrate transfer section than the substrate transfer means, the substrate holding means is located between the first substrate transfer means of the substrate transfer section and the second substrate transfer means of the intermediate chamber and therefore, the substrate can efficiently be transferred between the first and second substrate transfer means through the substrate holding means.

Even though the intermediate chamber in the module is further provided with the substrate holding means, because the plurality of the modules are piled up in a substantially vertical direction and separate from one another, and each of the plurality of the modules is detachably attached to the substrate transfer section, when any one of the modules requires a maintenance, it is possible to take out only the one module which requires the maintenance and to conduct the maintenance therefor. When the maintenance is completed, parallel and height relationships and so forth between the second substrate transfer means and the substrate processing chamber and between the second substrate transfer means and the substrate holding means are adjusted beforehand to allow the substrate or the substrates to be transferred among the substrate processing chamber, the second substrate transfer means and the substrate holding means in the module. After the adjustment, the module is attached to the substrate transfer section again. Because it is possible to conduct, in the module, the adjustment for the substrate transfer among the substrate processing chamber, the second substrate transfer means and the substrate holding means, such adjustment operation can easily and accurately be conducted. After that, when the module for which the maintenance has been conducted is attached to the substrate transfer section, it is unnecessary anymore to conduct the adjustment for the substrate transfer among the substrate processing chamber, the second substrate transfer means and the substrate holding means and therefore, it is possible to remarkably enhance the net working rate of the substrate processing apparatus.

According to a second aspect of the present invention, there is provided a second substrate processing apparatus, comprising:
a substrate transfer section;
a plurality of modules, each of the plurality of modules being detachably mounted to the substrate transfer section; and
first substrate transfer means provided in the substrate transfer section and capable of transferring a substrate or substrates to the plurality of modules,
   wherein the plurality of modules are piled up, separately from one another, in a substantially vertical direction,
   wherein each of the plurality of modules comprises:
   a substrate processing chamber, having a hermetic structure, for processing the substrate or the substrates;
   first and second intermediate chambers provided between the substrate processing chamber and the substrate transfer section, each of the first and second intermediate chambers having a hermetic structure, the first intermediate chamber being located closer to the substrate processing chamber than the second intermediate chamber, and the second intermediate chamber being located closer to the substrate transfer section than the first intermediate chamber;
   a first valve provided between the substrate processing chamber and the first intermediate chamber, the first valve being capable of establishing hermetic isolation between the substrate processing chamber and the first intermediate chamber when the first valve is closed and being capable of allowing the substrate or the substrates to pass through the first valve when the first valve is opened;
   a second valve provided between the first intermediate chamber and the second intermediate chamber, the second valve being capable of establishing hermetic isolation between the first intermediate chamber and the second intermediate chamber when the second valve is closed and being capable of allowing the substrate or the substrates to pass through the second valve when the second valve is opened; and
   a third valve provided between the second intermediate chamber and the substrate transfer section, the third valve being capable of establishing hermetic isolation between the second intermediate chamber and the substrate transfer section when the third valve is closed and being capable of allowing the substrate or the substrates to pass through the third valve when the third valve is opened,
   wherein the second intermediate chamber is provided with substrate holding means capable of holding the substrate or the substrates, and
   wherein the first intermediate chamber is provided with second substrate transfer means capable of transferring the substrate or the substrates between the substrate holding means and the substrate processing chamber.

In the second substrate processing apparatus of the present invention, because the plurality of modules are piled up in a substantially vertical direction, even though the plurality of modules are used to enhance the processing efficiency of the substrate, an area of the clean room occupied by the substrate processing apparatus is not increased, and a maintenance region for the apparatus is not increased.

Further, in the second substrate processing apparatus, because the plurality of the modules piled up in the substantially vertical direction are separated from one another and each of the plurality of the modules is detachably attached to the substrate transfer section, when any one of the modules requires a maintenance, it is possible to take out only the one module which requires the maintenance. While the maintenance for the module is conducted, other modules can be operated and as a result, a net working rate of the substrate processing apparatus is remarkably enhanced.

Furthermore, in the second substrate processing apparatus, because the plurality of the modules piled up in the substantially vertical direction are separate from one another and each of the plurality of the modules is detachably attached to the substrate transfer section, when any one of the modules requires a maintenance, it is possible to take out only the one module which requires the maintenance and to conduct the maintenance therefor. When the maintenance is completed, parallel and height relationships and so forth between the second substrate transfer means and the substrate processing chamber and between the second substrate transfer means and the substrate holding means can be adjusted beforehand to allow the substrate to be transferred among the substrate processing chamber, the second substrate transfer means and the substrate holding means in the module. After the adjustment, the module is attached to the substrate transfer section again. Because it is possible to conduct, in the module, the adjustment for the substrate transfer among the substrate processing chamber, the second substrate transfer means and the substrate holding means, such adjustment operation can easily and accurately be conducted. After that, when the module for which the maintenance has been conducted is attached to the substrate transfer section, it is unnecessary anymore to conduct the adjustment for the substrate transfer among the substrate processing chamber, the second substrate transfer means and the substrate holding means and therefore, it is possible to remarkably enhance the net working rate of the substrate processing apparatus.

Also, because the plurality of the modules are separate from one another and each of the plurality of the modules is detachably attached to the substrate transfer section, the number of modules to be attached to the substrate transfer section can suitably be selected in accordance with a required number of the substrates to be processed per hour and a type of processing.

Further, each of the plurality of modules comprises: a substrate processing chamber, having a hermetic structure, for processing the substrate or the substrates; first and second intermediate chambers provided between the substrate processing chamber and the substrate transfer section, each of the first and second intermediate chambers having a hermetic structure, the first intermediate chamber being located closer to the substrate processing chamber than the second intermediate chamber, and the second intermediate chamber being located closer to the substrate transfer section than the first intermediate chamber; a first valve provided between the substrate processing chamber and the first intermediate chamber, the first valve being capable of establishing hermetic isolation between the substrate processing chamber and the first intermediate chamber when the first valve is closed and being capable of allowing the substrate or the substrates to pass through the first valve when the first valve is opened; a second valve provided between the first intermediate chamber and the second intermediate chamber, the second valve being capable of establishing hermetic isolation between the first intermediate chamber and the second intermediate chamber when the second valve is closed and being capable of allowing the substrate or the substrates to pass through the second valve when the second valve is opened; and a third valve provided between the second intermediate chamber and the substrate transfer section, the third valve being capable of establishing hermetic isolation between the second intermediate chamber and the substrate transfer section when the third valve is closed and being capable of allowing the substrate or the substrates to pass through the third valve when the third valve is opened. Therefore, it is possible to independently keep the first and second intermediate chambers and the substrate processing chamber in each of the modules in respective hermetically sealed states. Also, in each of the modules and between the modules, it is possible to independently bring an interior of each of the first and second intermediate chambers and the substrate processing chamber into a predetermined gas atmosphere or a vacuum atmosphere, and the substrate or the substrates can be moved between the substrate processing chamber and the first intermediate chamber, between the first intermediate chamber and the second intermediate chamber, and between the second intermediate chamber and the substrate transfer section, respectively. Because it is possible to independently keep the first and second intermediate chambers and the substrate processing chamber in respective hermetically sealed states, the second intermediate chamber can function as a load lock chamber. As the first and second valves, gate valves are preferably used.

Further, because the first intermediate chamber of each of the modules is provided with the second substrate transfer means capable of transferring the substrate or the substrates between the substrate holding means and the substrate processing chamber, it is possible to transfer the substrate or the substrates into and out from the substrate processing chamber irrespective of the processing states of substrate processing chambers of other modules. Because each of the modules is provided with the substrate processing chamber and substrate transfer means, the substrate or the substrates can be transferred out irrespective of the processing states in other substrate processing chambers and as a result, a time period in which the substrate is heated in each of the modules can be kept constant.

Because the second intermediate chamber is provided with the substrate holding means capable of holding the substrate or the substrates, it is possible to separate the holding function and the transferring function of the substrate. Therefore, for example, while the substrate holding means holds some substrate or substrates for cooling, the second substrate transfer means can transfer other substrate or substrates to the substrate processing chamber and therefore, the substrate processing can be performed more efficiently.

In the second substrate processing apparatus, the second intermediate chamber includes the substrate holding means, but does not include the second substrate transfer means and therefore, it is possible to reduce a volume of the second intermediate chamber. As a result, it is possible to shorten a replacement time of atmosphere in the second intermediate chamber, for example, and to shorten a changing time between an atmospheric pressure state and a reduced pressure state.

In the second substrate processing apparatus, each of the plurality of modules preferably comprises:
the substrate processing chamber, having a hermetic structure of vacuum level, for processing the substrate or the substrates;
the first and second intermediate chambers provided between the substrate processing chamber and the substrate transfer section, each of the first and second intermediate chambers having a hermetic structure of vacuum level, the first intermediate chamber being located closer to the substrate processing chamber than the second intermediate chamber, and the second intermediate chamber being located closer to the substrate transfer section than the first intermediate chamber;
the first valve provided between the substrate processing chamber and the first intermediate chamber, the first valve being capable of establishing hermetic isolation of vacuum level between the substrate processing chamber and the first intermediate chamber when the first valve is closed and being capable of allowing the substrate or the substrates to pass through the first valve when the first valve is opened;
the second valve provided between the first intermediate chamber and the second intermediate chamber, the second valve being capable of establishing hermetic isolation of vacuum level between the first intermediate chamber and the second intermediate chamber when the second valve is closed and being capable of allowing the substrate or the substrates to pass through the second valve when the second valve is opened; and
the third valve provided between the second intermediate chamber and the substrate transfer section, the third valve being capable of establishing hermetic isolation of vacuum level between the second intermediate chamber and the substrate transfer section when the third valve is closed and being capable of allowing the substrate or the substrates to pass through the third valve when the third valve is opened.

With the above described features, it is possible to independently keep the first and second intermediate chambers and the substrate processing chamber of each of the modules in respective hermetically sealed states of vacuum level. In each of the modules and between the modules, it is possible to independently bring an interior of each of the first and second intermediate chambers and the substrate processing chamber into a predetermined vacuum atmosphere, and the substrate or the substrates can be moved between the substrate processing chamber and the first intermediate chamber, between the first intermediate chamber and the second intermediate chamber, and between the second intermediate chamber and the substrate transfer section, respectively. Because it is possible to independently keep the first and second intermediate chambers and the substrate processing chamber in respective hermetically sealed states of vacuum level, the second intermediate chamber can function as a load lock chamber used under vacuum.

Because the first intermediate chamber having such a hermetic structure of vacuum level is provided with the second substrate transfer means capable of transferring the substrate or the substrates between the substrate holding means and substrate processing chamber, the substrate or the substrates can be transferred under atmospheric pressure to each of the modules by the first substrate transfer means provided in the substrate transfer section, and the transfer of the substrate or the substrates under vacuum can be performed by the second substrate transfer means provided in the first intermediate chamber of each of the modules. Therefore, it is unnecessary that all the regions in which mechanisms for transferring the substrate have the hermetic structures of vacuum level. That is, the substrate transfer section which transfers the substrate or the substrates to each of the modules can be a region in which the substrate or the substrates are transferred under atmospheric pressure, and a region having a hermetic structure of vacuum level can be divided into the first intermediate chamber of each of the modules. As a result, it is possible to simplify the structures of the substrate transfer section and the first substrate transfer means, and they can be manufactured at a low price. A volume of the first intermediate chamber of each of the modules can be reduced, and even though the wall thickness of the first intermediate chamber is made thin, its strength can be maintained and as a result, it can be manufactured at a low price. Further, it is possible to minimize a vertical movement of the second substrate transfer means provided in the first intermediate chamber, it can be manufactured at a low price. It is also possible to suppress, to the minimum, particles which may be generated from the driving section of the second substrate transfer means in the first intermediate chamber having the hermetic structure of vacuum level.

Because the second intermediate chamber similarly having the hermetic structure of vacuum level is also provided in each of the modules, each of the volumes of the second intermediate chambers can be reduced, and even though the wall thickness of the second intermediate chambers is reduced, strength can be maintained. As a result, it can be manufactured at a low price.

In the second substrate processing apparatus, when the substrate processing chamber and the first and second intermediate chambers have hermetic structures of vacuum level, it is preferable that the substrate processing chamber and the first and second intermediate chambers can be reduced in pressure. In such a case, it is more preferable that the substrate processing chamber and the first and second intermediate chambers can be independently reduced in pressure.

Each of the first and second substrate processing apparatuses of the present invention is preferably used when the substrate transfer section is a section that transfers the substrate or the substrates under atmospheric pressure.

When the substrate transfer section is the section that transfers the substrate or the substrates under atmospheric pressure, a structure of the first substrate transfer means provided in the substrate transfer section can be simple, and it can be manufactured at a low price. In addition, it is unnecessary to place the substrate transfer section in a chamber having a hermetic structure, and it is enough to simply cover the substrate transfer section with a housing. Therefore, its structure can be simple and its manufacturing cost can be reduced.

Each of the first and second substrate processing apparatuses especially functions effectively when the substrate transfer section is a section that transfers the substrate or the substrates under atmospheric pressure, and the substrate processing chamber is a chamber that processes the substrate under a reduced pressure.

In each of the first and second substrate processing apparatuses, the substrate holding means is preferably a heat-resistant substrate holding means.

When the substrate holding means is of heat-resistant, each of the intermediate chamber in the first substrate processing apparatus and the first intermediate chamber in the second substrate processing apparatus can be used as a substrate cooling chamber for cooling a high-temperature substrate after it is processed in the substrate processing chamber.

The heat-resistant substrate holding means is preferably made of quartz, glass, ceramics or metal. If the substrate holding means is made of such material, even when the intermediate chamber or the first intermediate chamber is brought into a vacuum atmosphere, impurities such as outgas are not generated from the substrate holding means. Therefore, it is possible to keep the atmosphere in the intermediate chamber or the first intermediate chamber clean. As ceramics, a sintered SiC, a sintered SiC on which SiO₂ film is CVD coated, an alumina and the like are preferably used.

In each of the first and second substrate processing apparatuses, preferably, the substrate transfer section is further provided with a cassette holding means for holding a cassette capable of accommodating a plurality of the substrates, and the first substrate transfer means is capable of transferring the substrate or the substrates between the cassette held by the cassette holding means and the plurality of modules.

In this case, preferably, the first substrate transfer means is provided with a structure capable of transferring the cassette.

With the above feature, the first substrate transfer means can function as both the substrate transfer means and the cassette transfer means. Therefore, a single elevator means can commonly be used for the substrate transfer means and the cassette transfer means, which makes it possible to reduce a manufacturing cost of the elevator apparatus, and to reduce a floor space occupied by the substrate transfer section, resulting in reducing an area occupied by the substrate processing apparatus.

In each of the first and second substrate processing apparatuses, preferably, by further providing the substrate transfer section with the elevator capable of bringing the first substrate transfer means up and down, the first substrate transfer means can work for each of the modules.

In each of the first and second substrate processing apparatuses, preferably, the substrate transfer section is further provided with a cassette introducing section for transferring the cassette into the substrate transfer section and carrying out the cassette from the substrate transfer section, and the cassette introducing section is disposed at a predetermined height which is different from the height of the cassette holding means.

In a semiconductor manufacturing plant, in order to be compatible with an automatic transfer robot, a height at which a cassette is introduced is determined in each of apparatuses in many cases. In the substrate processing apparatus of the present invention, the cassette introduction section is located at a predetermined height as described above so as to be compatible with the automatic transfer robot. In this case, it is necessary to transfer the substrate from a cassette introduced into the cassette introduction section to each of the modules. In the present invention, the first substrate transfer means is provided with a structure capable of transferring the cassette, the substrate transfer section is provided with the elevator capable of vertically moving the first substrate transfer means, and the substrate transfer section is provided with the cassette holding means for holding the cassette. With such structures, a cassette accommodating a plurality of substrates can be first transferred to a predetermined cassette holding means by the elevator and the first substrate transfer means and then, the substrates can be transferred from the cassette to each of the modules by the first substrate transfer means. Therefore, the efficiency for transferring the substrates between the cassette introduction section and each of the modules is enhanced.

In each of the first and second substrate processing apparatuses of the present invention, it is preferable that the substrate processing apparatus can process the plurality of substrates simultaneously, and the second substrate transfer means can transfer the same number of substrates as the plurality of substrates to be simultaneously processed by the substrate processing apparatus. With these features, the substrate processing efficiency is enhanced.

In each of the first and second substrate processing apparatuses of the present invention, preferably, the following processes are effected: a film formation of an insulation film, a wiring metal film, a polycrystalline silicon film, an amorphous film and the like by using various CVD methods such as a plasma enhanced CVD method, a hot wall CVD method, a photo enhanced CVD; an etching; a heat treatment such as annealing; an epitaxial growth; a diffusion, etc. Especially preferably, a plasma processing for processing substrates utilizing plasma such as plasma enhanced etching, plasma enhanced CVD and plasma enhanced ashing, is conducted. In this case, preferably, the substrate processing apparatus is provided with the second substrate holding means capable of holding the plurality of substrates laterally arranged side by side, and the substrate transfer means can simultaneously transfer the plurality of substrates laterally arranged side by side.

With the above features, it is possible to substantially equalize respective distances between the plurality of the substrates and the electrode of the plasma processing apparatus. As a result, density of the plasma to which the plurality of the substrates are exposed becomes uniform among the substrates and therefore, the plasma processing can be conducted uniformly among the substrates.

In each of the first and second substrate processing apparatuses of the present invention, preferably, the substrate processing apparatus is capable of processing a plurality of the substrates simultaneously, and the second substrate transfer means is capable of transferring the plurality of substrates one by one to respective their processing positions where the plurality of substrates are to be simultaneously processed.

With the above feature, it is unnecessary to change a structure of the second substrate transfer means in accordance with the number of substrates which can be processed simultaneously by the substrate processing apparatus.

As the substrate to be processed in the present invention, a semiconductor wafer is preferably used. In such a case, the substrate processing apparatus functions as a semiconductor wafer processing apparatus.

Further, a glass substrate for a liquid crystal display element, etc., can be used as the substrate.

### BRIEF DESCRIPTION OF THE DRAWINGS

The above and further objects, features and advantages of the present invention will become more apparent from the following detailed description taken in conjunction with the accompanying drawings, wherein:
Figs.1A and 1B are plan view and sectional view, respectively, for explaining a semiconductor wafer processing apparatus according to a first embodiment of the present invention;
Figs.2 and 3 are sectional views for explaining the semiconductor wafer processing apparatus according to the first embodiment of the present invention;
Figs.4 and 5 are plan views for explaining the semiconductor wafer processing apparatus according to the first embodiment of the present invention;
Fig.6 is a plan view for explaining a load lock chamber in the semiconductor wafer processing apparatus according to the first embodiment of the present invention;
Fig.7 is a sectional view for explaining the load lock chamber in the semiconductor wafer processing apparatus according to the first embodiment of the present invention;
Fig.8 is a plan view for explaining the load lock chamber in the semiconductor wafer processing apparatus according to the first embodiment of the present invention;
Fig.9 is a sectional view for explaining the load lock chamber in the semiconductor wafer processing apparatus according to the first embodiment of the present invention;
Fig.10 is a schematic perspective view for explaining a cassette transfer-cum-wafer transfer robot used in first to third embodiments of the present invention;
Fig.11A is a side view for explaining a pitch changing mechanism for a cassette transfer-cum-wafer transfer robot used in first to third embodiments of the present invention;
Fig.11B is a rear view taken along the line Y-Y in Fig.11A;
Figs.12A and 12B are plan view and sectional view, respectively, for explaining a semiconductor wafer processing apparatus according to a second embodiment of the present invention;
Figs.13A and 13B are plan view and sectional view, respectively, for explaining the semiconductor wafer processing apparatus according to the second embodiment of the present invention;
Figs.14 and 15 are a sectional views for explaining a semiconductor wafer processing apparatus according to a third embodiment of the present invention;
Figs.16, 17, 18 and 19 are plan views for explaining the semiconductor wafer processing apparatus according to the third embodiment of the present invention; and
Fig.20 is a plan view for explaining a conventional semiconductor wafer processing apparatus.

### DESCRIPTION OF THE PREFERRED EMBODIMENTS

### (First Embodiment)

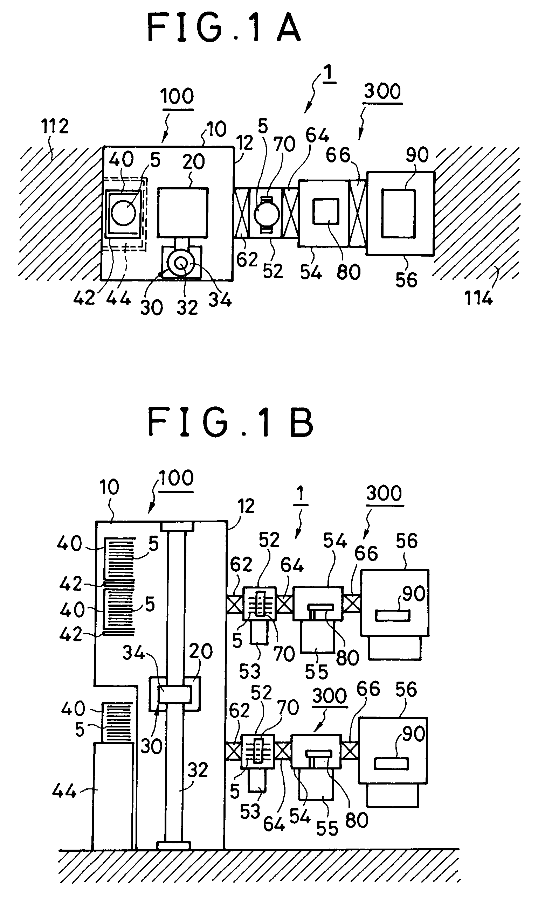

Referring to Fig.1A to 9, a semiconductor wafer processing apparatus 1 according to the first embodiment will be explained by taking the case of a plasma CVD apparatus.

The semiconductor wafer processing apparatus 1 includes a cassette loader unit 100 and two connection modules 300.

The cassette loader unit 100 includes a cassette loader chamber 10 having a chamber wall 12 to which the two connection modules 300 are respectively detachably attached. The two connection modules 300 are piled up at a distance in a vertical direction.

Because the plurality of connection modules 300 are piled up in a vertical direction in this manner, even though the processing efficiency of the wafers 5 is enhanced by using the plurality of connection modules 300, the space occupied in a clean room by the semiconductor wafer processing apparatus 1 is not increased.

Further, maintenance areas of the semiconductor wafer processing apparatus 1 are only a maintenance area 112 at the side of the cassette loader unit 100 and a maintenance area 114 at the side of a reaction processing chamber 56. Therefore, even though the processing efficiency of the wafers 5 is enhanced by using the plurality of connection modules 300, maintenance areas of the semiconductor wafer processing apparatus 1 is not increased.

Further, because the plurality of connection modules 300 are piled up in a vertical direction and are separate from one another, and each of the plurality of the connection modules 300 is detachably attached to the chamber wall 12 of the cassette loader chamber 10, when any one of the connection modules 300 requires a maintenance, only the connection module 300 which requires the maintenance can easily be detached. Furthermore, even when the maintenance is carried out for such a connection module 300, other connection modules 300 can be operated. As a result, a net working rate of the semiconductor wafer processing apparatus 1 is remarkably enhanced.

Furthermore, because the plurality of connection modules 300 are piled up in a vertical direction and are separate from one another, and each of the plurality of the connection modules 300 is detachably attached to the chamber wall 12 of the cassette loader chamber 10, when any one of the connection modules 300 requires a maintenance, only the connection module 300 which requires the maintenance is detached to carrying out the maintenance. When the maintenance is completed, parallel and height relationships and so forth between a wafer transfer robot 80 and a susceptor 90 in the reaction processing chamber 56 as well as between the wafer transfer robot 80 and a wafer boat 70 can be adjusted beforehand to allow the wafers 5 to be transferred among the susceptor 90 in the reaction processing chamber 56, the wafer transfer robot 80 and the wafer boat 70 in the connection module 300. After the adjustments are completed, the connection module 300 is attached to the chamber wall 12 of the cassette loader chamber 10 again. Because the adjustments for transferring the wafers 5 among the susceptor 90 in the reaction processing chamber 56, the wafer transfer robot 80 and the wafer boat 70 can be conducted beforehand in this manner, it is possible to conduct such adjustments easily and accurately. After that, when the adjusted connection module 300 is attached to the chamber wall 12 of the cassette loader chamber 10, it is unnecessary to conduct the adjustments for transferring the wafers 5 among the susceptor 90 in the reaction processing chamber 56, the wafer transfer robot 80 and the wafer boat 70 in the connection module 300. Therefore, it is possible to remarkably enhance the net working rate of the semiconductor wafer processing apparatus 1.

The maintenance operations of the connection module 300 include, for example, detaching the reaction processing chamber 56 to conduct cleaning of the reaction processing chamber 56, then attaching the reaction processing chamber 56 again, and repairing or replacing the wafer transfer robot 80 when it is broken down. After such maintenance is conducted, it is necessary to adjust the parallel and height relationships between the wafer transfer robot 80 and the susceptor 90 in the reaction processing chamber 56 as well as between the wafer transfer robot 80 and the wafer boat 70. According to the present embodiment, such adjustments can separately be conducted for every connection module 300 beforehand. Therefore, the adjustment operations can be easily and accurately conducted, and the net working rate of the semiconductor wafer processing apparatus 1 can be enhanced remarkably.

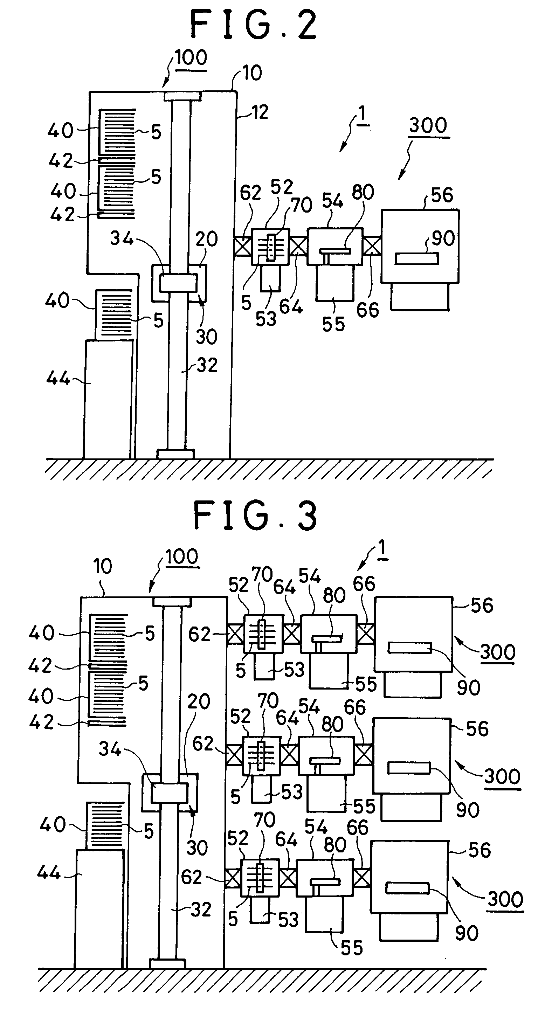

Furthermore, because each of the plurality of the connection modules 300 is detachably mounted to the wall 12 of the cassette loader chamber 10 and the plurality of the connection modules 300 are separate from one another, the number of the modules to be mounted to the chamber wall 12 of the cassette loader chamber 10 can be appropriately selected in accordance with the number of wafers required to be processed per hour and type of processing. For example, the substrate processing apparatus may assume a single-stage module structure as shown in Fig.2, or a three-stage module structure as shown in Fig.3.

In each of the connection modules 300, an outer gate vale 62, a load lock chamber 52, a gate valve 64, a transfer chamber 54, a gate valve 66 and a reaction processing chamber 56 are connected and disposed in this order from the side of the cassette loader chamber 10.

Each of the load lock chamber 52, the transfer chamber 54 and the reaction processing chamber 56 has a hermetic structure of vacuum level, and it is possible to independently be evacuated to be respective predetermined vacuum atmospheres.

A susceptor 90 is provided in the reaction processing chamber 56. Plasma CVD is conducted in the reaction processing chamber 56. The susceptor 90 has a structure to hold two semiconductor wafers 5 laterally side by side.

When the two semiconductor wafers 5 are held laterally side by side in this manner, it is possible to make distances between the two wafers 5 and an electrode of the plasma processing apparatus substantially equal to each other and as a result, density of the plasma to which the two wafers 5 are exposed becomes uniform between the substrates and therefore, the plasma processing can be conducted uniformly between the wafers 5.

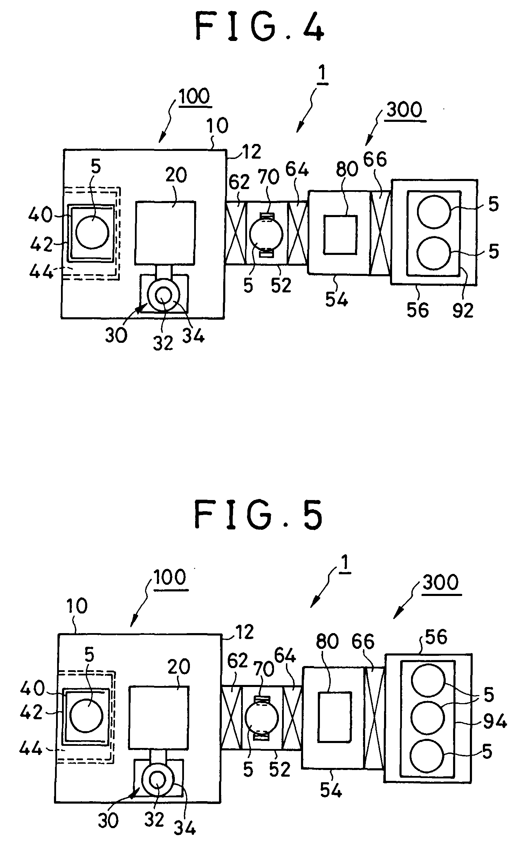

Because the two wafers 5 are simultaneously processed in the reaction processing chamber 56, the processing efficiency is enhanced. The number of wafers 5 to be processed simultaneously can be appropriately selected depending on a size of the wafer 5 or type of processing. For example, it is possible to dispose three wafers 5 laterally to process the three wafers 5 simultaneously as shown in Fig.5.

A wafer transfer robot 80 and a driving device 55 for driving the wafer transfer robot 80 are provided in the transfer chamber 54. The wafer transfer robot 80 can transfer the wafers 5 between a wafer boat 70 and the susceptor 90.

Because the transfer chamber 54 of each of the connection modules 300 is provided with the wafer transfer robot 80 which can transfer the wafers 5 between the wafer boat 70 and the susceptor 90 in this manner, it is possible to transfer the wafers 5 from and into the reaction processing chamber 56 irrespective of the processing state in the reaction processing chamber 56 of the other connection modules 300. Because each of the connection modules 300 is provided with the reaction processing chamber 56 and the wafer transfer robot 80 in this manner, it is possible to carry out the wafers 5 irrespective of the processing state in the other reaction processing chambers 56 and as a result, it is possible to constantly keep a time period in which the wafers 5 are heated in each of the connection modules 300.

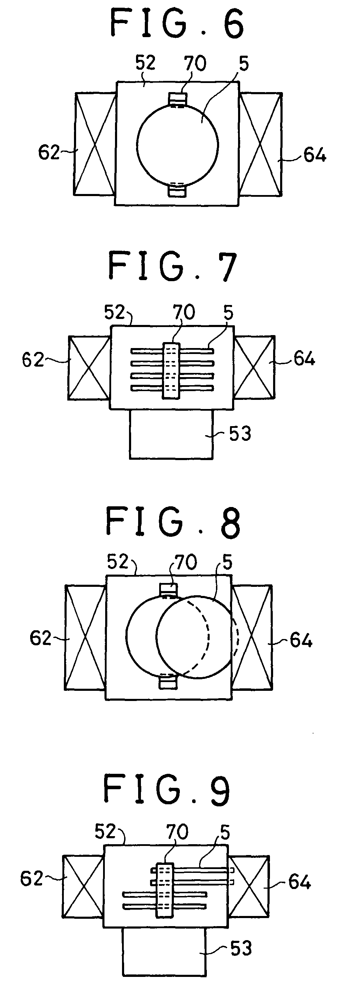

The load lock chamber 52 is provided therein with the wafer boat 70 and a lift 53 for bringing the wafer boat 70 up and down. The wafer boat 70 is provided with four slots as shown in Figs.6 to 8. Upper two of the four slots are for wafers before reaction processing, and the remaining lower two slots are for wafers after reaction processing. In this manner, positions of the slots corresponding to the transfer directions are allocated to the wafer boat 70. The wafer boat 70 can hold the wafers twice as many as wafers to be processed simultaneously in the reaction processing chamber 56. Figs.6 and 7 show a state in which two wafers 5 before being reaction processed are held in the upper two slots, and two wafers 5 after being processed are held in the lower two slots. Figs.8 and 9 show a state the upper two wafers 5 are being transferred to the reaction processing chamber 56.

The wafer boat 70 provided in the load lock chamber 52 can hold wafers 5 twice as many as wafers 5 to be processed simultaneously in the reaction processing chamber 56. Therefore, while wafers 5 are processed in the reaction processing chamber 56, it is possible to hold wafers 5 to be processed next in the upper two slots of the wafer boat 70 of the load lock chamber 52 beforehand. After the wafers 5 which have been processed are taken out from the reaction processing chamber 56 into the lower two slots of the wafer boat 70, wafers 5 which are to be processed next can be immediately supplied to the reaction processing chamber 56. As a result, it is possible to process the wafers 5 efficiently to enhance the throughput.

The wafer transfer robot 80 can transfer two wafers 5 between the wafer boat 70 and the susceptor 90 simultaneously. Therefore, it is possible to transfer wafers 5 of the same number of the wafers 5 to be simultaneously processed in the reaction processing chamber. Because the wafer transfer robot 80 can transfer a plurality of wafers 5 simultaneously, and can transfer wafers 5 of the same number of the wafers 5 to be simultaneously processed in the reaction processing chamber, the transferring efficiency of the wafers 5 is enhanced, and the throughput is also enhanced.

Because the load lock chamber 52 is provided with the lift 53 for bringing the wafer boat 70 up and down, it is possible to transfer a wafer 5 to a predetermined slot of the wafer boat 70 and as a result, the structure of the wafer transfer robot 80 is simplified and thus, the substrate processing apparatus can be manufactured at a low price.

Further, because the load lock chamber 52 is provided therein with the wafer boat 70, and the transfer chamber 54 is provided therein the wafer transfer robot 80, a holding function and a transferring function of the wafers 5 can be separated. Therefore, for example, while the wafer boat 70 holds wafers 5 for cooling the same, it is possible to transfer other wafers 5 to the reaction processing chamber 56 by the wafer transfer robot 80. Therefore, it is possible to process the wafers 5 more efficiently.

The wafer boat 70 is a heat-resistant boat and thus, a high-temperature wafer 5 which has been processed in the reaction processing chamber 56 can be held by the wafer boat 70 and cooled.

The wafer boat 70 is preferably made of quartz, glass, ceramics or metal. If the wafer boat 70 is made of such material, impurities such as outgas are not generated from the wafer boat 70 even in a vacuum atmosphere and therefore, it is possible to keep the atmosphere clean. As ceramics, a sintered SiC, a sintered SiC on which SiO₂ film and so forth is CVD coated, an alumina and the like are preferably used.

The cassette loader chamber 10 is provided therein with a plurality of cassette shelves for holding cassettes and thus, it is possible to hold a plurality of cassettes 40. A cassette loader 44 is disposed outside the cassette loader chamber 10 and at a lower position thereof. The cassette loader 44 includes a mechanism capable of transferring the cassette 40 between the semiconductor wafer processing apparatus 1 and the outside. The cassette 40 is introduced into a predetermined introduction port (not shown) by the cassette loader 44. The cassette loader 44 can be provided therein with a mechanism for aligning an orientation flat of the wafers 5 accommodated in the cassette 40.

The cassette loader chamber 10 is provided therein with a cassette transferring-cum-wafer transferring robot 20 and an elevator 30 for lifting and lowering the cassette transferring-cum-wafer transferring robot 20. The elevator 30 includes a screw shaft 32 and an elevating portion 34. A nut (not shown) in the elevating portion 34 and the screw shaft 32 constitute a ball screw. When the screw shaft 32 is rotated, the elevating portion 34 is vertically moved, and in accordance with such movement, the cassette transferring-cum-wafer transferring robot 20 attached to the elevating portion 34 is vertically moved so that the cassette introduction port and the two connection modules 300 can be accessed by the robot 20. As will be described later with reference to Fig.6, the cassette transferring-cum-wafer transferring robot 20 includes a cassette transfer device 21 and a wafer transfer device 23.

As described above, the cassette loader chamber 10 is provided therein with the cassette transferring-cum-wafer transferring robot 20 to allow the wafers 5 to be transferred to the two connection modules 300, the transfer chamber 54 of the connection module 300 is provided with the wafer transfer robot 80 to allow the wafers 5 to be transferred to the reaction processing chamber 56. Therefore, transfer of the wafers 5 to each of the connection modules 300 and transfer of the wafers 5 within each of the modules 300 can be accomplished independently and as a result, the wafers can be transferred efficiently.

The transfer chamber 54 having a hermetic structure of vacuum level is provided with the wafer transfer robot 80, and the cassette loader chamber 10 is provided therein with the cassette transferring-cum-wafer transferring robot 20. Therefore, the wafers 5 can be transferred to each of the modules 300 under the atmosphere pressure by the cassette transferring-cum-wafer transferring robot 20 of the cassette loader chamber 10, and the transfer of the wafers 5 under vacuum can be effected by the wafer transfer robot of each of the connection modules 300. Thus, it is unnecessary that all the regions in which mechanisms for transferring the wafers 5 are installed should be made into hermetic structures of vacuum level, and the cassette loader chamber 10 in which the cassette transferring-cum-wafer transferring robot 20 for transferring the substrate to each of the connection modules 300 is disposed can be made into a region in which the wafers 5 are transferred under the atmospheric pressure. Therefore, a region having the hermetic structure of vacuum level can be divided into each of the connection modules 300. As a result, it is possible to simplify the structures of the cassette loader chamber 10 and the cassette transferring-cum-wafer transferring robot 20, and they can be manufactured at a low price. Further, volumes of the load lock chamber 52 and the transfer chamber 54 of each of the connection modules 300 can be made small, and even though thickness of their walls are made thinner, a sufficient strength can be kept. As a result, the entire apparatus can be manufactured at a low price. Furthermore, a vertical movement of the wafer transfer robot 80 provided in the transfer chamber 54 can be suppress to the required minimum value and thus, the wafer transfer robot 80 can also be manufactured at a low price. Also, in the transfer chamber 54 having the hermetic structure of vacuum level, particles which may possibly be generated from the driving device of the wafer transfer robot 80 can be suppress to the minimum.

Next, transfer and processing method of the wafers 5 will be explained.

The cassette 40 introduced into the cassette loader chamber 10 by the cassette loader 44 is mounted on the cassette transferring-cum-wafer transferring robot 20, brought upward by the elevator 30 and then, placed on the cassette shelf 42. Next, the wafers 5 are mounted on the wafer boat 70 of the load lock chamber 52 by the cassette transferring-cum-wafer transferring robot 20. In the present embodiment, two wafers 5 are transferred at a time from the cassette 40 to the upper two slots by the cassette transferring-cum-wafer transferring robot 20. When the wafers 5 are transferred to the load lock chamber 52 by the cassette transferring-cum-wafer transferring robot 20, the gate valve 64 is closed, and the outer gate valve 62 is opened.

After the wafers 5 are mounted on the wafer boat 70 in the load lock chamber 52, the outer gate valve 62 is closed to draw a vacuum in the load lock chamber 52.

After drawing a vacuum, the gate valve 64 is opened. A vacuum has been drawn in the transfer chamber 54 beforehand.

Then, the two wafers 5 are transferred under vacuum from the wafer boat 70 in the load lock chamber 52 to the susceptor 90 in the reaction processing chamber 56 by the wafer transfer robot 80 in the transfer chamber 54. At that time, the gate valve 66 is opened and a vacuum has been drawn in the reaction processing chamber 56.

After the wafers 5 are transferred to the susceptor 90, the gate valve 66 is closed and an interior of the reaction processing chamber 56 is brought into a predetermined atmosphere, and the two wafers 5 mounted on the susceptor 90 of the reaction processing chamber 56 are simultaneously subjected to a film formation processing by plasma CVD.

While the film formation processing is conducted by the plasma CVD, other wafers 5 which have not yet been processed are mounted to the upper two slots of the wafer boat 70 in the load lock chamber 52 in the same manner as described above.

After a predetermined film formation is conducted, a vacuum is drawn in the reaction processing chamber 56 and then, the gate valve 66 is opened. The two wafers 5 are moved under vacuum to the lower two slots of the wafer boat 70 in the load lock chamber 52 by the wafer transfer robot 80. At that time, because the wafers 5 which have not yet been processed are mounted in the upper two slots of the wafer boat 70, these two wafers 5 are immediately transferred to the susceptor 90 in the reaction processing chamber 56 by the wafer transfer robot 80 in the wafer transfer chamber 54.

By supplying the wafers 5 which have not yet processed to the load lock chamber 52, and keeping in the vacuum atmosphere, it is possible to shorten the transferring time of the non-processed wafers 5.

After that, the gate valve 64 is closed to bring an interior of the load lock chamber 52 into atmospheric pressure using nitrogen or the like, and the wafers 5 are cooled down to a predetermined temperature there.

Then, the outer gate valve 62 is opened, and the wafers 5 are transferred into the cassette 40 by the wafer transfer device 23 of the cassette transferring-cum-wafer transferring robot 20.

When the predetermined number of wafers 5 are transferred into the cassette 40, the cassette 40 is lowered by the cassette transfer device 21 of the cassette transferring-cum-wafer transferring robot 20 and then, is transferred out from the cassette loader chamber 10.

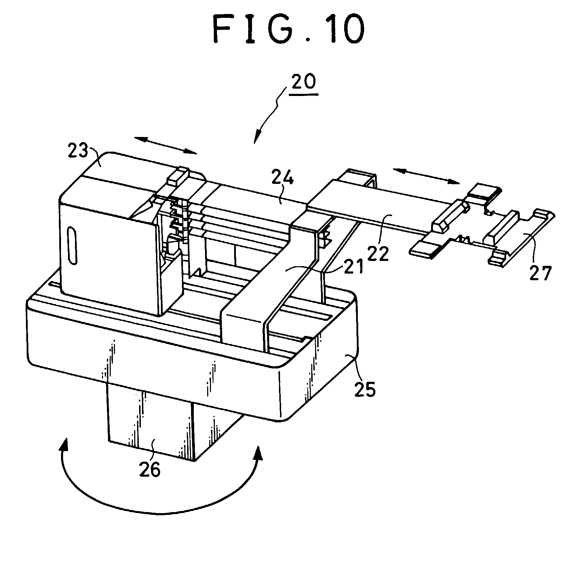

Fig.10 is a schematic perspective view for explaining a cassette transfer-cum-wafer transfer robot 20 used in the first and second embodiments of the present invention.

The cassette transfer device 21 and the wafer transfer device 23 are provided on bases 25 and 26. The cassette transfer device 21 and the wafer transfer device 23 can move independently to each other in parallel in a direction of the arrows. The cassette transfer device 21 includes a cassette transfer arm 22 that is provided at its tip end with a cassette holder 27. The cassette 10 is mounted on the cassette holder 27 and is transferred. The wafer transfer device 23 includes a plurality of tweezers 24. The wafers 5 are mounted on the tweezers 24 and are transferred.

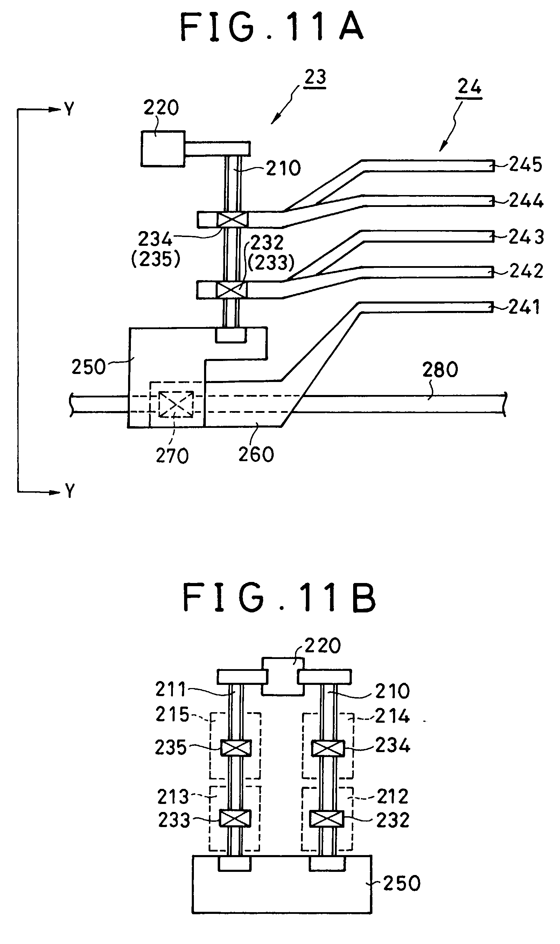

Figs.11A and 11B are views for explaining a pitch changing mechanism for the cassette transfer-cum-wafer transfer robot 20 used in first and second embodiments of the invention, wherein Fig.11A is a side view and Fig.11B is a rear view taken along the line Y-Y in Fig.11A.

In the present embodiment, the wafer transfer device 23 includes five tweezers 241 to 245. The tweezers 241 is integrally formed with a block 260. Nuts 232, 233, 234 and 235, are secured to the tweezers 242, 243, 244 and 245, respectively. The nuts 232 and 234 are meshed with a screw shaft 210. Each of the nuts 232 and 234 constitutes a ball screw by cooperation with the screw shaft 210. Each of the nuts 233 and 235 is meshed with a screw shaft 211 to constitute a ball screw by cooperation with the screw shaft 211. An upper end of the screw shaft 210 and an upper end of the screw shaft 211 are interconnected with a motor 220 through a gear mechanism (not shown). Lower ends of the screw shafts 210 and 211 are rotatably mounted to the a block 250. A nut 270 is mounted to the blocks 250 and 260, and is meshed with a screw shaft 280. The nut 270 and the screw shaft 280 constitute a ball screw. When the screw shaft 280 is rotated, the nut 270 is laterally moved to move the tweezers 241 to 245 laterally.

That region 212 of the screw shaft 210 which is meshed with the nut 232 is formed with threads having one time pitch. That region 213 of the screw shaft 211 which is meshed with the nut 233 is formed with threads having two times pitch. That region 214 of the screw shaft 210 which is meshed with the nut 234 is formed with threads having three times pitch. That region 215 of the screw shaft 211 which is meshed with the nut 235 is formed with threads having four times pitch. Relative positions between the blocks 250 and 260 in a vertical direction are not varied. When the screw shafts 210 and 211 are rotated by the motor 220, the blocks 250 and 260 are not vertically moved, the nut 232 is vertically moved through a predetermined distance, the nut 233 is vertically moved through a distance two times the distance of the block 232, the nut 234 is vertically moved through a distance three times the distance of the block 232, and the nut 235 is vertically moved through a distance four times the distance of the block 232. Therefore, the tweezers 241 do not vertically move, the tweezers 242 vertically move through a predetermined distance, the tweezers 243 vertically move through a distance two times the distance of tweezers 242, the tweezers 244 vertically move through a distance three times the distance of tweezers 242, and the tweezers 245 vertically move through a distance four times the distance of tweezers 242. As a result, it is possible to change the pitches among the tweezers 241 to 245 while constantly keeping the differences in the pitches among the tweezers 241 to 245.

For example, when a film formation or the like is conducted without using plasma in the reaction processing chamber 56, wafers 5 are stacked and processed to reduce the occupied floor space. In such a case, it is necessary to provide an interval between the plurality of wafers 5 so as to keep the film thickness uniform taking into consideration the gas flow in the reaction processing chamber 56 and the like. When the wafers 5 are transferred in the plant or factory, cassettes or the like are used in many cases. However, an interval between grooves of the cassettes is usually different from the interval that can keep the film thickness uniform. Therefore, it is necessary to change the pitch between the wafers 5 at any of the places.

Therefore, if the cassette transfer-cum-wafer transfer robot 20 includes the pitch changing mechanism, the pitch can be changed under the atmospheric pressure. This structure is simpler than a structure to change the pitch under vacuum, and therefore, it is possible to manufacture it at a lower price, and to suppress the particles from being generated. Further, because the pitch between the wafers 5 can be changed by the cassette transfer-cum-wafer transfer robot 20, the wafer transfer robot need not have a structure that can change the pitch and thus, its structure can be simplified, and the wafer transfer robot can be manufactured at a low price. In this case, it is preferable that intervals between the wafers 5 held by the wafer boat 70 of the load lock chamber 52 are substantially equal to the intervals between the wafers 5 in the reaction processing chamber 56.

### (Second Embodiment)

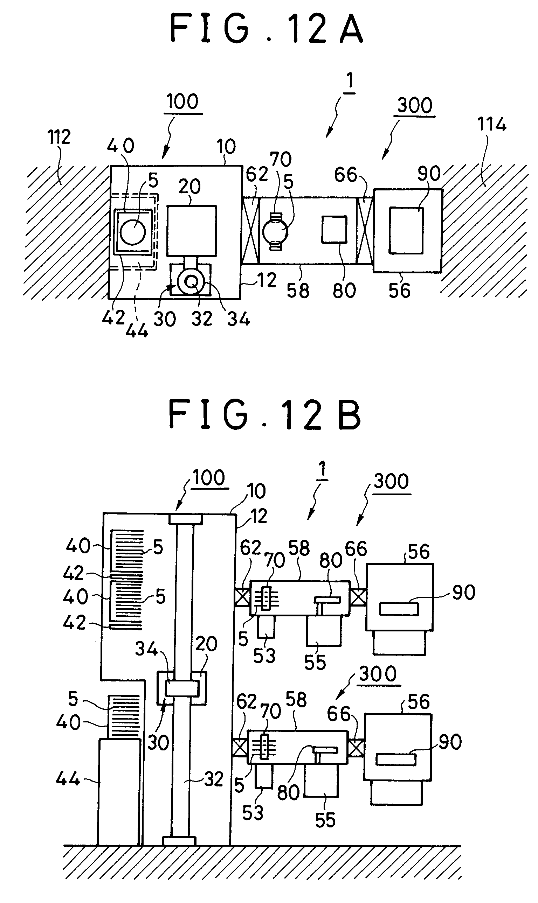

Figs.12A and 12B are views for explaining a semiconductor wafer processing apparatus according to a second embodiment of the present invention, wherein Fig.12A is a plan view and Fig.12B is a sectional view.

In the above described first embodiment, the gate valve 64 is provided between the load lock chamber 52 and the transfer chamber 54. In the second embodiment, such a gate valve is not provided, and the wafer boat 70 and the wafer transfer robot 80 are provided in a common load lock-cum-transfer chamber 58. Other structure is the same as that of the first embodiment.

### (Third Embodiment)

A third embodiment will be explained while taking the case of a plasma CVD apparatus for forming a nitride film or oxide film on a wafer, as a semiconductor wafer processing apparatus 2.

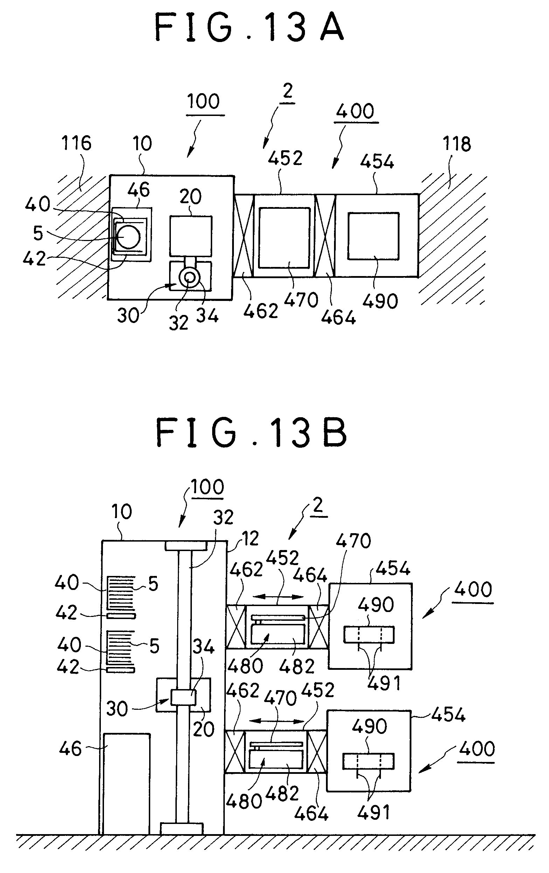

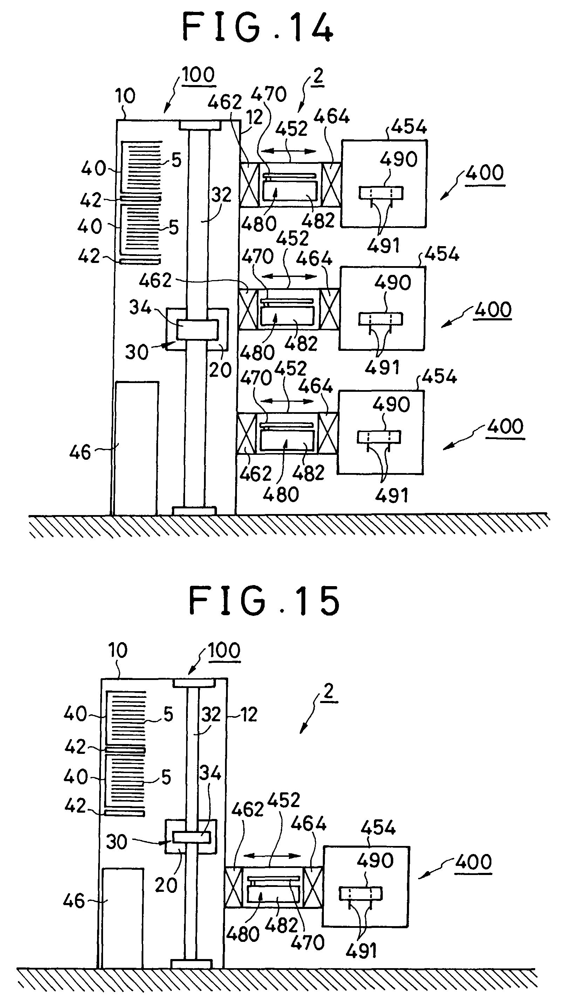

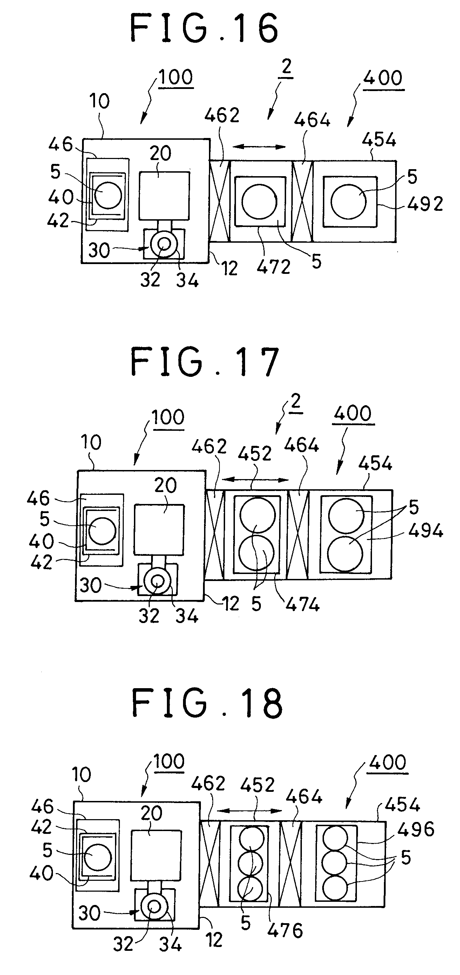

Figs.13A and 13B are views for explaining a semiconductor wafer processing apparatus according to the third embodiment of the invention, wherein Fig.13A is a plan view, and Fig.13B is a sectional view. Figs.14 and 15 are sectional views and Figs.16 to 19 are plan views, all for explaining the semiconductor wafer processing apparatus of the third embodiment.

The semiconductor wafer processing apparatus 2 comprises: a cassette loader unit 100 in which the elevator 30 and the cassette transferring-cum-wafer transferring robot 20 capable of transferring the wafers 5 vertically and horizontally; gate valves 462 and 464 for opening and closing a gate of each of connection modules 400; a load lock-cum-transfer chamber 452 which is provided therein with a wafer transfer robot 480 for transferring the wafers and which is capable of transferring the wafers between the cassette loader unit 100 and the reaction processing chamber 454 without changing a pressure of the reaction processing chamber 454; and the reaction processing chamber 454 for processing the wafers 5. Each of the connection modules 400 are connected hermetically.

The gate valve 462, the load lock-cum-transfer chamber 452, the gate valve 464 and the reaction processing chamber 454 which are connected to one another are referred to as a connection module 400 hereinafter.

The connection modules 400 are disposed at multiple-stage so that an area occupied by the apparatus can be reduced even if the number of the reaction processing chambers 454 is increased.

It is also possible to further reduce the area occupied by the apparatus by providing maintenance spaces 116 and 118 for the apparatus only in front of and behind the apparatus (in Fig.13A, at left and right sides of the apparatus).

Next, the cassette loader unit 100 will be explained.

The cassette loader unit 100 is provided with the cassette loader 46 so that the cassette 40 can be transferred from and to the outside of the semiconductor processing apparatus. The cassette loader unit 100 is optionally provided therein with a mechanism for aligning an orientation flat of the wafer 5 accommodated in the cassette 40.

The cassette loader 46 is provided at its upper portion with the plurality of cassette shelves 42 in which the plurality of cassettes 40 can be accommodated.

The cassette loader unit 100 is provided at its corner with the elevator 30 for vertically moving the cassette transfer-cum-wafer transfer robot 20 which transfers the wafers 5 and the cassette 40.

The cassette transfer-cum-wafer transfer robot 20 comprises a wafer transfer mechanism and a cassette transfer mechanism.

The load lock-cum-transfer chamber 452 will be explained next.

The load lock-cum-transfer chamber 452 is provided therein with a uniaxial wafer transfer robot 480 comprising a finger 470 for placing the wafers 5 thereon and transferring the wafers 5 from and into the reaction processing chamber 454 and a driving device 484 for the finger 470. A moving direction of the finger 470 is shown by the arrow in the drawings.

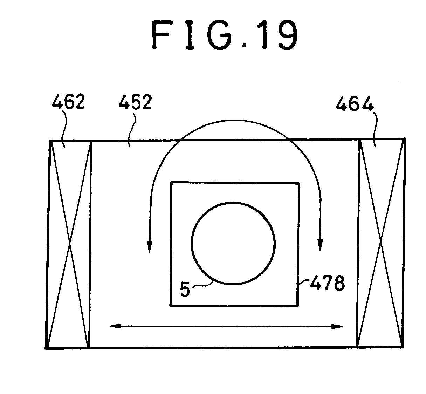

The wafer transfer robot 480 provided in the load lock-cum-transfer chamber 452 may have a finger 470 which is able to rotate, and move forward and backward as shown by arrows in Fig.19.

Fig.13B shows the connection modules 400 provided in two-stage. However, in order to increase the throughput, the connection modules 400 may be provided in three-stage as shown in Fig.14. Even if the number of stages is increased, the area occupied by the semiconductor processing apparatus is not varied, which is a feature of the present embodiment.

Fig.15 shows a single-stage connection module 400, which can be realized by removing the upper connection module 400 from the apparatus of the two-stage connection modules 400 shown in Fig.13B.

The number of stages of the connection modules 400 is determined by the required processing ability. The connection module 400 can easily be attached and detached by a connection module mounting mechanism provided in a housing of the apparatus which is not shown and therefore, the most suitable system can be established.

The number of wafers 5 to be processed in the reaction processing chamber 454 at a time can be one as shown in Fig.16, two as shown in Fig.17, and three as shown in Fig.18. The number of wafers 5 is suitably determined in accordance with a size of the wafer 5 or a required processing condition.

When a diameter of the wafer is 8 inches, the suitable number of wafers to be processed at a time is 1 or 2.

A construction of the wafer transfer robot 480 of the load lock-cum-transfer chamber 452 is also varied depending on the number of the wafers 5 to be processed at a time in the reaction processing chamber 454.

When the number of wafers 5 to be processed at a time in the reaction chamber 454 is one, the number of wafers 5 to be placed on the finger 472 is one as shown in Fig.16. But when the number of wafers 5 to be processed at a time in the reaction processing chamber 454 is two as shown in Fig.17, the suitable number of wafers 5 to be placed on the finger 474 is two, so as to shorten the transferring time.

Similarly, when three wafers 5 are to be processed at a time in the reaction processing chamber 454, the suitable number of wafers 5 to be placed on the finger 476 is three as shown in Fig.18.

If the finger 478 of the wafer transfer robot 480 provided in the load lock-cum-transfer chamber 452 can rotate and move forward and backward as shown in Fig.19, even though the number of wafers 5 to be processed at a time in the reaction processing chamber 454 is two or three, the number of wafers 5 to be placed on the finger 478 can be one.

If it is necessary to commonize all of the wafer transfer robots 480 provided in load lock-cum-transfer chambers 452, a suitable robot will be a single-wafer placing type robot as shown in Fig.19.

The operation will be explained next.

The cassette 40 having the wafers 5 therein is placed on the cassette loader 46 in the cassette loader unit 100 from the outside of the semiconductor processing apparatus by a manual or automatic cassette transfer mechanism, and a position of the cassette 40 is adjusted.

When the orientation flat of the wafer 5 is aligned, an orientation flat alignment mechanism which is not shown is operated to align the orientation flat.

After the position of the cassette 40 placed on the cassette loader 46 is adjusted, the cassette 40 on the cassette loader 46 is transferred to the upper cassette shelf 42 utilizing the cassette transfer-cum-wafer transfer robot 20 and the elevator 30.

Because a plurality of cassette shelves 42 are provided, a plurality of cassettes 40 can be accommodated. Although it is considered that six cassettes 40 at the maximum will be sufficient, the number of cassettes should be suitably determined in accordance with a need. Although the number of cassettes 40 to be accommodated at the time of working of the apparatus varies depending on the ability of a production line, the cassettes 40 before and after the processing are usually mixed and accommodated at the time of working of the apparatus.

The wafers 5 which have not yet been processed and accommodated in the cassette 40 on the cassette shelf 42 are transferred onto the finger 470 of the wafer transfer robot 480 in the load lock-cum-transfer chamber 452 by cooperation of the cassette transfer-cum-wafer transfer robot 20 and the elevator 30.

At that time, the load lock-cum-transfer chamber 452 is under the atmospheric pressure, the gate valve 462 between the cassette loader unit 100 and the load lock-cum-transfer chamber 452 is left opening, and the wafers 5 are in a condition that they can be transferred into and from the load lock-cum-transfer chamber 452 by the cassette transfer-cum-wafer transfer robot 20 of the cassette loader unit 100.

After the wafers 5 are placed on the finger 470 of the wafer transfer robot 480 in the load lock-cum-transfer chamber 452, the gate valve 462 between the cassette loader unit 100 and the load lock-cum-transfer chamber 452, the load lock-cum-transfer chamber 462 is evacuated until the pressure therein becomes substantially equal to that in the reaction processing chamber 454 by a pump which is not shown.

When the evacuating operation of the load lock-cum-transfer chamber 452 is completed, the gate valve 464 between the load lock-cum-transfer chamber 452 and the reaction processing chamber 454 is opened, and the finger 470 is moved toward the reaction processing chamber 454 to place the wafers 5 onto the susceptor 490 in the reaction processing chamber 454. There exist various ways for placing the wafers 5 onto the susceptor 490, but a common way is to place the wafers by cooperation of the finger 470 and a wafer transfer pin 491 provided in the susceptor 5.

After the wafers 5 are placed on the susceptor 490, the gate valve 464 between the load lock-cum-transfer chamber 452 and the reaction processing chamber 454 is closed to supply a process gas into the reaction processing chamber 454 to set the pressure to a predetermined value and then, plasma is created by RF power to process the wafers 5.

After the process of the wafers 5 is completed, the gate valve 464 between the load lock-cum-transfer chamber 452 and the reaction processing chamber 454 is opened, the wafers 5 are received onto the finger 470 by cooperation of the finger 470 of the wafer transfer robot 480 in the load lock-cum-transfer chamber 452 and the wafer transfer pin 491 provided in the susceptor 490 in the reaction processing chamber 454, and the finger 470 is returned to the load lock-cum-transfer chamber 452.

Then, the gate valve 464 between the load lock-cum-transfer chamber 452 and the reaction processing chamber 454 is closed, and nitrogen is usually introduced into the load lock-cum-transfer chamber 452 to bring the pressure therein into the atmospheric pressure. During that time, an interior of the reaction chamber 454 is cleaned using plasma.

When the pressure in the load lock-cum-transfer chamber 452 is brought into the atmospheric pressure, the gate valve 462 between the cassette loader unit 100 and the load lock-cum-transfer chamber 452 is opened, and the wafers 5 on the finger 470 are accommodated in predetermined slots of predetermined cassette 40 on the cassette shelf 42 using the cassette transfer-cum-wafer transfer robot 20 of the cassette loader unit 100.

The above described series of operations is repeated to process the wafers 5 accommodated in the cassette 40 on the cassette shelf 42.

According to the present embodiment, as described above, even though the number of connection modules including reaction processing chambers is increased so as to increase the throughput, a floor space occupied by the apparatus is not increased. Further, the floor space can be reduced by providing maintenance spaces for the apparatus in front of and behind the apparatus.

According to the present embodiment, the throughput can be enhanced by processing two or more wafers at a time in the reaction processing chamber.

Further, according to the present embodiment, the number of substrates such as wafers to be transferred at a time by the robot provided in the load lock-cum-transfer chamber is set to be the same number of substrates to be processed at a time in the reaction processing chamber. Therefore, a transferring time of the wafers between the load lock-cum-transfer chamber and the reaction processing chamber can be made short and thus, the throughput can be enhanced.

Further, because the plurality of connection modules 400 are piled up in a vertical direction and are separate from one another, and each of the plurality of the connection modules 300 is detachably attached to the chamber wall 12 of the cassette loader chamber 10 of the cassette loader unit 100, when any one of the connection modules 400 requires a maintenance, only the connection module 400 which requires the maintenance can easily be detached. Furthermore, even when the maintenance is carried out for such a connection module 400, other connection modules 400 can be operated. As a result, a net working rate of the semiconductor wafer processing apparatus 2 is remarkably enhanced.

Furthermore, because the plurality of connection modules 400 are piled up in a vertical direction and are separate from one another, and each of the plurality of the connection modules 400 is detachably attached to the chamber wall 12 of the cassette loader chamber 10, when any one of the connection modules 400 requires a maintenance, only the connection module 400 which requires the maintenance is detached to carrying out the maintenance. When the maintenance is completed, parallel and height relationships and so forth between the wafer transfer robot 480 and a susceptor 490 in the reaction processing chamber 454 can be adjusted beforehand to allow the wafers 5 to be transferred between the susceptor 490 in the reaction processing chamber 454 and the wafer transfer robot 480 in the connection module 400. After the adjustments are completed, the connection module 400 is attached to the chamber wall 12 of the cassette loader chamber 10 again. Because the adjustments for transferring the wafers 5 between the susceptor 490 in the reaction processing chamber 454 and the wafer transfer robot 480 can be conducted beforehand in this manner, it is possible to conduct such adjustments easily and accurately. After that, when the adjusted connection module 400 is attached to the chamber wall 12 of the cassette loader chamber 10, it is unnecessary to conduct the adjustments for transferring the wafers 5 between the susceptor 490 in the reaction processing chamber 454 and the wafer transfer robot 480 in the connection module 400. Therefore, it is possible to remarkably enhance the net working rate of the semiconductor wafer processing apparatus 2.

The maintenance operations of the connection module 400 include, for example, detaching the reaction processing chamber 454 to conduce cleaning of the reaction processing chamber 454, then attaching the reaction processing chamber 454 again, and repairing or replacing the wafer transfer robot 480 when it is broken down. After such maintenance is conducted, it is necessary to adjust the parallel and height relationships between the wafer transfer robot 480 and the susceptor 490 in the reaction processing chamber 454. According to the present embodiment, such adjustments can separately be conducted for every connection module 400 beforehand. Therefore, the adjustment operations can be easily and accurately be conducted, and the net working rate of the semiconductor wafer processing apparatus 2 can be enhanced remarkably.

## Claims

1. A substrate processing apparatus, comprising:
a substrate transfer section;
a plurality of modules, each of said plurality of modules being detachably attached to said substrate transfer section; and
first substrate transfer means provided in said substrate transfer section and capable of transferring a substrate or substrates to said plurality of modules,
wherein said plurality of modules are piled up, separately from one another, in a substantially vertical direction,
wherein each of said plurality of modules comprises:
a substrate processing chamber, having a hermetic structure, for processing said substrate or said substrates;
an intermediate chamber having a hermetic structure and being provided between said substrate processing chamber and said substrate transfer section;
a first valve provided between said substrate processing chamber and said intermediate chamber, said first valve being capable of establishing hermetic isolation between said substrate processing chamber and said intermediate chamber when said first valve is closed and being capable of allowing said substrate or said substrates to pass through said first valve when said first valve is opened; and
a second valve provided between said intermediate chamber and said substrate transfer section, said second valve being capable of establishing hermetic isolation between said intermediate chamber and said substrate transfer section when said second valve is closed and being capable of allowing said substrate or said substrates to pass through said second valve when said second valve is opened, and
wherein said intermediate chamber is provided with second substrate transfer means capable of transferring said substrate or said substrates to said substrate processing chamber.

2. A substrate processing apparatus as recited in claim 1, wherein each of said plurality of modules comprises:
said substrate processing chamber, having a hermetic structure of vacuum level, for processing said substrate or said substrates;
said intermediate chamber having a hermetic structure of vacuum level and being provided between said substrate processing chamber and said substrate transfer section;
said first valve provided between said substrate processing chamber and said intermediate chamber, said first valve being capable of establishing hermetic isolation of vacuum level between said substrate processing chamber and said intermediate chamber when said first valve is closed and being capable of allowing said substrate or said substrates to pass through said first valve when said first valve is opened; and
said second valve provided between said intermediate chamber and said substrate transfer section, said second valve being capable of establishing hermetic isolation of vacuum level between said intermediate chamber and said substrate transfer section when said second valve is closed and being capable of allowing said substrate or said substrates to pass through said second valve when said second valve is opened.

3. A substrate processing apparatus as recited in claim 2, wherein said substrate processing chamber and said intermediate chamber can be independently reduced in pressure.

4. A substrate processing apparatus as recited in any one of claims 1 to 3, wherein said intermediate chamber of each of said plurality of modules is further provided with substrate holding means capable of holding said substrate or said substrates, said substrate holding means being positioned closer to said substrate transfer section than said second substrate transfer means.

5. A substrate processing apparatus, comprising:
a substrate transfer section;
a plurality of modules, each of said plurality of modules being detachably mounted to said substrate transfer section; and
first substrate transfer means provided in said substrate transfer section and capable of transferring a substrate or substrates to said plurality of modules,
wherein said plurality of modules are piled up, separately from one another, in a substantially vertical direction,
wherein each of said plurality of modules comprises:
a substrate processing chamber, having a hermetic structure, for processing said substrate or said substrates;
first and second intermediate chambers provided between said substrate processing chamber and said substrate transfer section, each of said first and second intermediate chambers having a hermetic structure, said first intermediate chamber being located closer to said substrate processing chamber than said second intermediate chamber, and said second intermediate chamber being located closer to said substrate transfer section than said first intermediate chamber;
a first valve provided between said substrate processing chamber and said first intermediate chamber, said first valve being capable of establishing hermetic isolation between said substrate processing chamber and said first intermediate chamber when said first valve is closed and being capable of allowing said substrate or said substrates to pass through said first valve when said first valve is opened;
a second valve provided between said first intermediate chamber and said second intermediate chamber, said second valve being capable of establishing hermetic isolation between said first intermediate chamber and said second intermediate chamber when said second valve is closed and being capable of allowing said substrate or said substrates to pass through said second valve when said second valve is opened; and
a third valve provided between said second intermediate chamber and said substrate transfer section, said third valve being capable of establishing hermetic isolation between said second intermediate chamber and said substrate transfer section when said third valve is closed and being capable of allowing said substrate or said substrates to pass through said third valve when said third valve is opened,
wherein said second intermediate chamber is provided with substrate holding means capable of holding said substrate or said substrates, and
wherein said first intermediate chamber is provided with second substrate transfer means capable of transferring said substrate or said substrates between said substrate holding means and said substrate processing chamber.

6. A substrate processing apparatus as recited in claim 5, wherein each of said plurality of modules comprises:
said substrate processing chamber, having a hermetic structure of vacuum level, for processing said substrate or said substrates;
said first and second intermediate chambers provided between said substrate processing chamber and said substrate transfer section, each of said first and second intermediate chambers having a hermetic structure of vacuum level, said first intermediate chamber being located closer to said substrate processing chamber than said second intermediate chamber, and said second intermediate chamber being located closer to said substrate transfer section than said first intermediate chamber;
said first valve provided between said substrate processing chamber and said first intermediate chamber, said first valve being capable of establishing hermetic isolation of vacuum level between said substrate processing chamber and said first intermediate chamber when said first valve is closed and being capable of allowing said substrate or said substrates to pass through said first valve when said first valve is opened;
said second valve provided between said first intermediate chamber and said second intermediate chamber, said second valve being capable of establishing hermetic isolation of vacuum level between said first intermediate chamber and said second intermediate chamber when said second valve is closed and being capable of allowing said substrate or said substrates to pass through said second valve when said second valve is opened; and
said third valve provided between said second intermediate chamber and said substrate transfer section, said third valve being capable of establishing hermetic isolation of vacuum level between said second intermediate chamber and said substrate transfer section when said third valve is closed and being capable of allowing said substrate or said substrates to pass through said third valve when said third valve is opened.

7. A substrate processing apparatus as recited in claim 6, wherein said substrate processing chamber, said first intermediate chamber and said second intermediate chamber can be independently reduced in pressure.

8. A substrate processing apparatus as recited in any one of claims 1 to 7, wherein said substrate transfer section transfers said substrate or said substrates under atmospheric pressure.

9. A substrate processing apparatus as recited in claim 8, wherein said substrate processing chamber is a substrate processing chamber wherein said substrate is or said substrates are processed under a reduced pressure.

10. A substrate processing apparatus as recited in any one of claims 4 to 7, wherein said substrate holding means is a heat-resistant substrate holding means.

11. A substrate processing apparatus as recited in any one of claims 1 to 10, wherein said substrate transfer section is further provided with a cassette holding means for holding a cassette capable of accommodating a plurality of said substrates, said first substrate transfer means being capable of transferring said substrate or said substrates between said cassette held by said cassette holding means and said plurality of modules.

12. A substrate processing apparatus as recited in claim 11, wherein said first substrate transfer means is provided with a structure capable of transferring said cassette.

13. A substrate processing apparatus as recited in any one of claims 1 to 12, wherein said substrate transfer section is further provided with an elevator capable of vertically moving said first substrate transfer means.

14. A substrate processing apparatus as recited in claim 13, wherein said substrate transfer section is further provided with a cassette introducing section for transferring said cassette into said substrate transfer section and carrying out said cassette from said substrate transfer section, said cassette introducing section being disposed at a predetermined height which is different from the height of said cassette holding means.

15. A substrate processing apparatus as recited in any one of claims 1 to 14, wherein said substrate processing apparatus is capable of processing a plurality of said substrates simultaneously, and said second substrate transfer means is capable of transferring simultaneously the same number of substrates as said plurality of substrates to be simultaneously processed by said substrate processing apparatus.

16. A substrate processing apparatus as recited in claim 15, wherein said substrate processing apparatus is a plasma enhanced processing apparatus for processing said substrates utilizing plasma, said substrate processing apparatus includes second substrate holding means capable of holding said plurality of substrates with the substrates being laterally arranged side by side, and said substrate transfer means is capable of transferring simultaneously said plurality of substrates with the substrates being laterally arranged side by side.

17. A substrate processing apparatus as recited in any one of claims 1 to 14, wherein said substrate processing apparatus is capable of processing a plurality of said substrates simultaneously, and said second substrate transfer means is capable of transferring said plurality of substrates one by one to respective their processing positions where said plurality of substrates are to be simultaneously processed.
